Europäisches Patentamt

European Patent Office

Office européen des brevets

(11) Veröffentlichungsnummer: **0 453 834 A1**

(12) **EUROPÄISCHE PATENTANMELDUNG**

(21) Anmeldenummer: **91105315.5**

(22) Anmeldetag: **04.04.91**

(51) Int. Cl.5: **G01R 33/34**

(30) Priorität: **25.04.90 DE 4013111**

(43) Veröffentlichungstag der Anmeldung:
**30.10.91 Patentblatt 91/44**

(84) Benannte Vertragsstaaten:
**CH FR GB LI**

(71) Anmelder: **SPECTROSPIN AG**
**Industriestrasse 26**
**CH-8117 Fällanden(CH)**

(72) Erfinder: **Marek, Daniel, Dr.**
**Marchsteinweg 2**
**CH-5115 Möriken(CH)**

(74) Vertreter: **KOHLER SCHMID + PARTNER**
**Patentanwälte**
**Ruppmannstrasse 27**
**W-7000 Stuttgart 80(DE)**

(54) **HF-Empfangsspulenanordnung für NMR-Spektrometer.**

(57) Bei einem Kernspinresonanz-Spektrometer mit in einem homogenen Magnetfeld angeordneter, ungefähr auf Zimmertemperatur oder höherer Temperatur befindlicher Probe (1), und einer um die Probe (1) angeordneten, auf weit unter Zimmertemperatur gekühlten HF-Empfangsspule (3) zum Empfang von Kernspinresonanzsignalen aus der Probe (1) stehen zumindest Teile der HF-Empfangsspule (3) in wärmeleitendem Kontakt mit einer gekühlten Plattform (7). Die Anschlußleitungen der HF-Empfangsspule (3), die Resonatoraußenwand (10), der Vorverstärker sowie die Kühlmittel-Transferleitungen können durch kaltes Rückflußgas gekühlt werden. Durch diese Anordnung der HF-Empfangsspule (3) wird ein optimaler Füllfaktor erreicht, das thermische Rauschen des Empfangssystems drastisch erniedrigt, die Güte des Resonanzkreises erhöht und dadurch das Signal-Rauschverhältnis verbessert.

Fig. 3

Die Erfindung betrifft eine HF-Empfangsspulenanordnung für NMR-Spektrometer mit einer um eine in einem homogenen Magnetfeld angeordneter, ungefähr auf Zimmertemperatur oder höherer Temperatur befindlichen Probe angeordneten, auf weit unter Zimmertemperatur gekühlten HF-Emp-fangsspule zum Empfangen von Kernspinresonanz-signalen aus der Probe.

Eine solche Spektrometer-HF-Empfangsspulenanordnung ist bekannt aus einem Artikel von Hoult et al. im Journal of Magnetic Resonance 24, 71 - 85 (1976). Bei der dort beschriebenen Vorrichtung befindet sich die gesamte HF-Empfangsspule in einem mit einer kryogenen Flüssigkeit gekühlten Dewar und ist von der Probe durch ein doppelwandiges Glasgefäß vakuumisoliert. Der Hauptnachteil dieser klassischen Anordnung besteht darin, daß der Abstand zwischen Probe und HF-Empfangsspule mindestens um die Dicke von 2 Glaswänden plus den Vakuum enthaltenden Zwischenraum erhöht wird, was eine signifikante Verringerung des Füllfaktors nach sich zieht. Ein weiterer Nachteil ist die Lageempfindlichkeit des Systems und schließlich können auch aufsteigende Gasblasen der Kühlflüssigkeit zu einer Störung der Messung führen.

Aus Artikeln von Styles et al. (Journal of Magnetic Resonance 60, 397 - 404 (1984) und 84, 376 - 378 (1989)) ist eine verbesserte gekühlte HF-Empfangsspulenanordnung für ein Kernresonanzspektrometer bekannt. Bei diesem Aufbau befindet sich die HF-Empfangsspule im Vakuum, ist als hohles Röhrchen ausgebildet und wird von einer kryogenen Flüssigkeit durchströmt und somit von innen gekühlt. Durch die Anordnung der HF-Empfangsspule im Vakuum wird gegenüber dem oben beschriebenen klassischen Aufbau mit doppelwandigem Glasdewar eine dieser Wände eingespart. Ein wesentlicher Nachteil liegt jedoch darin, daß die Freiheit bei der Gestaltung der HF-Empfangsspule wesentlich eingeschränkt ist. Die sehr beschränkte Auswahl an verwendbaren Materialien erschwert eine Suszeptibilitätskompensation der HF-Empfangsspule und hat Einbußen in der Auflösung und Nachweisempfindlichkeit zur Folge. Auch ist die Herstellung einer solchen Spule schwierig und die Formgestaltungsmöglichkeit der Spule sehr beschränkt, da das die Spule bildende Röhrchen nicht mit beliebiger Formgebung herstellbar und auch nicht beliebig verformbar ist. Das führt unter anderem dazu, daß wiederum kein optimaler Füllfaktor erreicht werden kann. Außerdem wird wegen der notwendigen Lötstellen das Austauschen der HF-Empfangsspule behindert. Im Kühlbetrieb kann es zudem aufgrund des unter Druck durch das Röhrchen gepreßten kryogenen Mediums zu Vibrationen in der HF-Empfangsspule kommen, die Suszeptibilitätsänderungen zur Folge haben können, was die Qualität der Messung noch weiter herabsetzt. Schließlich wird in den beiden genannten Veröffentlichungen darauf hingewiesen, daß die Anordnung mit innen gekühlter HF-Empfangsspule experimentell lediglich ungefähr die halbe theoretisch erwartete Verbesserung im Signal-Rausch-Verhältnis erbrachte.

Aufgabe der vorliegenden Erfindung ist es demgegenüber, eine HF-Empfangsspulenanordnung nach dem Oberbegriff des Anspruchs 1 zu schaffen, bei der die durch den Betrieb des Empfangssystems bei tiefen Temperaturen erzielte Verbesserung des Signal-Rausch-Verhältnisses auch voll realisiert werden kann, indem die sich aus der gekühlten Anordnung der Empfangsspule ergebende Einbuße am Füllfaktor minimiert wird.

Diese Aufgabe wird nach der Erfindung dadurch gelöst, daß zumindest Teile der HF-Empfangsspule in wärmeleitendem Kontakt mit einer gekühlten Plattform stehen.

Dieser Aufbau erlaubt es, die HF-Empfangsspule zu kühlen und von der Probe thermisch zu isolieren, ohne daß ihre Formgebung noch ihr Material wesentlichen Einschränkungen unterworfen ist. Die HF-Empfangsspule kann eine fast beliebige Geometrie aufweisen, so daß kein Platz innerhalb der Spule durch die Isolation zur Probe verschenkt werden muß und somit ein optimaler Füllfaktor und damit eine hohe Güte des Resonanzkreises erzielt werden kann. Die kompakte Bauweise ermöglicht einen Einsatz dieser Nachweisanordnung auch in einem Hochfeldmagnetsystem mit entsprechend kleiner Magnetbohrung. Ein weiterer Vorteil ist die leichte Auswechselbarkeit der HF-Empfangsspule, deren elektrische Anschlüsse nicht wie im Falle der innengekühlten Hohlspule vakuumdicht angeschlossen oder angelötet sein müssen, sondern die mit einer einfachen Lötstelle oder z. B. mit einer einfachen Steck- oder Schraubverbindung nach außen geführt werden können. Dadurch, daß das kryogene Medium mit der Spule nicht direkt in Berührung kommt, können auch kaum Vibrationen durch den Fluß des kryogenen Mediums auf die HF-Empfangsspule übertragen werden.

Bei einer Ausführungsform der Erfindung besteht die HF-Empfangsspule aus einer auf ein Sub-strat aufgebrachten elektrisch leitenden, insbeson-dere supraleitfähigen Schicht. Durch die extrem geringe räumliche Ausdehnung der Schicht kann ein besonders hoher Füllfaktor erreicht werden. Besonders vorteilhaft ist die Verwendung von hochtemperatur-supraleitendem Schichtmaterial. Das Substrat, auf das die elektrisch leitende Schicht aufgebracht ist, kann bei Ausführungsformen aus einem Saphirröhrchen bestehen, das entweder direkt mit dem kryogenen Medium in Verbindung steht oder zusammen mit einem im Substrat angebrachten Metallblock (Cu, Al, ...), der seinerseits die Wärmeableitung zum kryogenen Medium übernimmt, die gekühlte Plattform bilden.

Bei einer anderen Ausführungsform besteht die HF-Empfangsspule aus einem Metalldraht, insbesondere einem Draht, der hochreines Kupfer oder Aluminium enthält. Die gekühlte Plattform kann dann ebenfalls aus Metall bestehen, insbesondere ein Kupferblock sein. Bei einer vorteilhaften Ausgestaltung dieser Ausführungsform steht die HF-Empfangsspule entlang mindestens einer ihrer Anschlüsse in wärmeleitendem Kontakt mit der gekühlten Plattform, so daß die Spule selbst sehr nahe an der Probe angeordnet sein kann, was einen hohen Füllfaktor erbringt. Bei einer geometrisch besonders günstigen Anordnung steht die HF-Empfangsspule in wärmeleitendem Kontakt mit mindestens einem aus der gekühlten Plattform vorspringenden Kühlfinger.

Bei einer weiteren Ausführungsform steht die HF-Empfangsspule in der Spulenmitte in wärmeleitendem Kontakt mit der gekühlten Plattform, so daß ein HF-mäßig symmetrischer kalter Anschluß erzielt wird.

Bei einer bevorzugten Ausführungsform ist die HF-Empfangsspule im Bereich um die Probe im Vakuum angeordnet und von einem oder mehreren Strahlungsschilden umgeben. Durch die kalte Abschirmung der HF-Empfangsspule wird ein besonders hoher Gütefaktor Q des Resonators ermöglicht und thermisches Rauschen zusätzlich reduziert, da bei entsprechenden geometrischen Verhältnissen die Abschirmung einen Bestandteil des Empfangskreises bildet und somit für einen Teil der Dämpfung verantwortlich ist. Dieser Dämpfungsanteil koppelt jedoch einen u. U. nicht unwesentlichen Rauschanteil in den Empfangskreis ein. Dieses Rauschsignal ist nun stark von der Temperatur der Abschirmung abhängig.

Die gekühlte Ausführung der HF-Abschirmung hat zudem den Nebeneffekt, daß die Strahlungsbelastung der Empfangsspule bis auf die Hälfte erniedrigt wird.

Geringe Betriebskosten verursacht die Kühlung der Plattform mit flüssigem Stickstoff. Falls zur Herabsetzung des thermischen Rauschens niedrigere Betriebstemperaturen des Nachweissystems erreicht werden sollen, kann die Kühlung der Plattform mit flüssigem oder gasförmigem Helium erfolgen.

Wie bereits oben beschrieben, kann der HF-mäßig "kalte" Spulenanschluß problemlos (d. h. sowohl wärme- wie auch elektrisch leitend) mit einer metallischen Kühlplattform verbunden werden. Der HF-mäßig "heiße" Anschluß der Empfangsspule wird im allgemeinen mittels eines Transformationsnetzwerks mit einem Koaxialkabel verbunden, das dann zum Vorverstärker führt. In speziellen Fällen können jedoch sowohl das Transformationsnetzwerk und/oder das Koaxialkabel entfallen. Für die Gestaltung des HF-mäßig "heißen" Anschlusses der HF-Empfangsspule ist im Rahmen dieser Erfindung nur dessen thermische Gestaltung von Bedeutung.

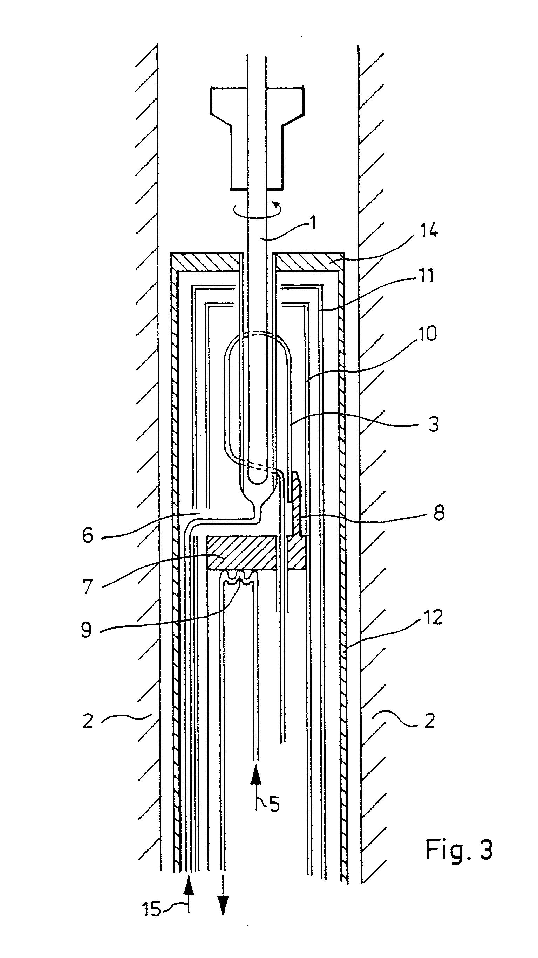

Bei einer Ausführungsform wird der HF-mäßig heiße Anschluß der Spule (z. B. durch eine Bohrung in der Kühlplattform) einfach mit dem Koaxialkabel (wie im Beispiel in Fig. 3) bzw. einem Transformationsnetzwerk oder auch direkt mit einem Vorverstärker verbunden. Die Kühlung des heißen Anschlusses muß dann über die ganze Empfangsspule erfolgen.

Bei einer anderen Ausführungsform wird der heiße Anschluss der Empfangsspule mittels eines thermisch gut leitenden Dielektrikums (z. B. Saphir) mit der Kühlplattform verbunden, und somit effizient gekühlt. Dadurch ergibt sich der sehr vorteilhafte Fall, daß die Empfangsspule von beiden Seiten her thermisch mit der Kühlplattform gekoppelt wird.

Bei einer weiteren Ausführungsform wird die Bohrung in der Kühlplattform mit einem elektrisch nicht leitfähigen Material abgedichtet. Somit kann sich die Empfangsspule selbst im Vakuum befinden, während der Anschluß im von einem Kühlmedium durchflossenen Raum fortgesetzt wird und somit sehr wirksam gekühlt werden kann.

Die beiden vorhergehenden Ausführungsformen können vorteilhafterweise kombiniert werden, indem die Durchführung aus einem thermisch gut leitenden Dielektrikum ausgeführt wird.

Die HF-Ankopplung zum kühlmitteldurchströmten Raum kann aber auch durch eine dielektrische Trennwand hindurch auf rein kapazitivem Weg erfolgen. Wird die Wand aus einem thermisch gut leitenden Dielektrikum ausgeführt, so ergibt sich eine sehr vorteilhafte Ausführungsvariante.

Bei einer bevorzugten Ausführungsform führt der gemäß obiger Beschreibung durch die gekühlte Plattform durchgeführte Anschluß der HF-Empfangsspule zu einem ebenfalls von Helium-Rückflußgas umgebenen Vorverstärker zur Verstärkung des Kernspinresonanz-Signales aus der Probe. Bei dieser Anordnung kühlt das Helium-Rückflußgas auch den Vorverstärker ab, was zu einer erheblichen Rauschverminderung führt. Der Vorverstärker kann speziell ein Galliumarsenid-Vorverstärker oder ein SQUID-Vorverstärker sein.

Bei einer bevorzugten weiteren Ausführungsform bildet die HF-Empfangsspule zusammen mit dem sie umgebenden Kühlsystem einen Meßkopf, der in das homogene Magnetfeld eingeschoben werden kann und eine Bohrung zur Aufnahme der Probe aufweist. Montage, Handhabung und Wartung sowie das Auswechseln eines so gestalteten Nachweissystemes sind besonders einfach.

Bei einer vorteilhaften Ausgestaltung ist das Kühlsystem als Durchflußkryostat ausgebildet, der mindestens eine Transferleitung für die Zufuhr flüssigen Heliums aus einem Vorratsbehälter aufweist. Die Transferleitung, die normalerweise ein dominierendes Kälteleck im Kühlsystem darstellt, ist während des gekühlten Betriebes des Kernspinresonanz-Spektrometers von Helium-Rückflußgas umgeben und wird daher auf billige und einfache Weise gekühlt.

Bei einer vorteilhaften Weiterbildung weist der Kryostat einen integrierten Vorratsbehälter für flüssiges Helium und/oder Stickstoff auf, was zur Senkung des Heliumverbrauchs bei kontinuierlichem gekühltem Betrieb beiträgt.

Schließlich ist bei einer anderen Ausführungsform das Kühlsystem als geschlossener Kühlkreislauf (Kryocooler) ausgebildet, also mit integrierter Helium-Rückgewinnung und -verflüssigung oder auch nur mit Zirkulation eines gasförmigen Kühlmediums ausgestattet.

Die Erfindung wird im folgenden anhand des in der Zeichnung dargestellten Ausführungsbeispiels näher beschrieben und erläutert. Die der Beschreibung und der Zeichnung zu entnehmenden Merkmale können bei anderen Ausführungsformen der Erfindung einzeln und für sich oder zu mehreren in beliebiger Kombination Anwendung finden. Es zeigen:

Fig. 1    eine schematische Schnittdarstellung einer herkömmlichen Anordnung mit gekühlter Empfangsspule in einem doppelwandigen Glasdewar;

Fig. 2    eine schematische Schnittdarstellung einer verbesserten bekannten Anordnung mit von innen durch direkten Fluß des kryogenen Mediums gekühlter Empfangsspule;

Fig. 3    eine schematische Schnittdarstellung einer Ausführungsform der erfindungsgemäßen HF-Empfangsspulenanordnung.

Bei Kernspinresonanz-Messungen an Proben mit Temperaturen von ca. 300 K (Zimmertemperatur) und darüber wird das Signal-Rausch-Verhältnis bedeutend verbessert, wenn die HF-Empfangsspule auf wesentlich niedrigerer Temperatur, z. B. 77 K (Stickstofftemperatur) oder 4.2 K (Heliumtemperatur) gehalten wird. Eines der wichtigsten Probleme in Bezug auf die konstruktive Auslegung einer solchen Apparatur ist die Frage der Kühlung der Spule und ihrer thermischen Isolation von der Probe. Dabei ist von erstrangiger Bedeutung, daß der Abstand der HF-Empfangsspule zur Probe möglichst klein bleibt, damit der Füllfaktor so wenig wie möglich verringert wird.

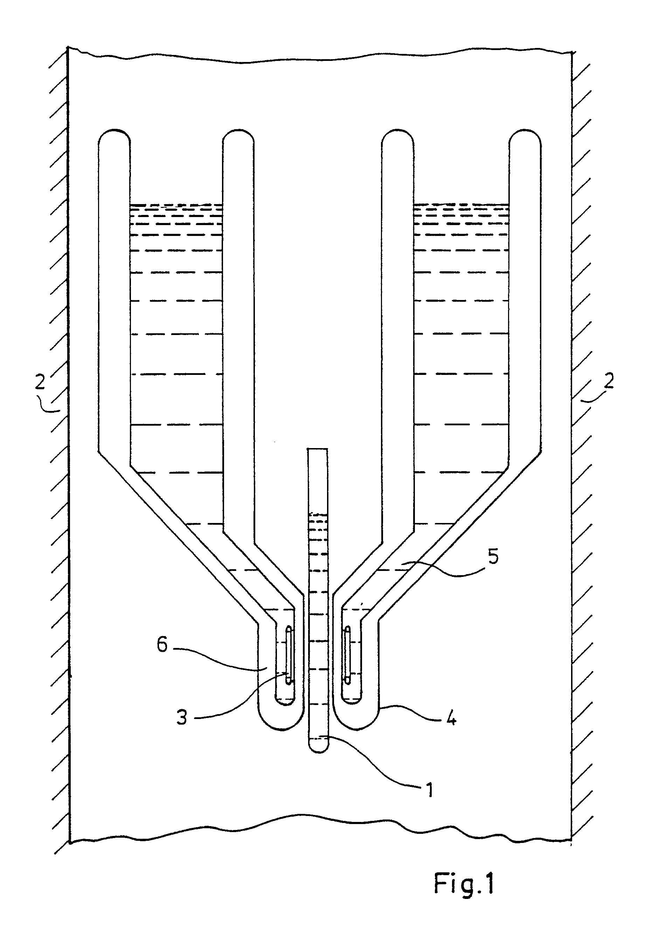

Bei der in Fig. 1 gezeigten klassischen Lösung befindet sich die Probe 1 im homogenen Feld des Magneten 2 und ist von der HF-Empfangsspule 3 umgeben, die in einem Glasdewar angeordnet ist, der mit einer kryogenen Flüssigkeit 5 (z. B. Stickstoff oder Helium) gefüllt ist, und der einen doppelwandigen Aufbau mit Vakuum 6 zwischen den beiden Wänden aufweist. Es ist klar ersichtlich, daß bei diesem klassischen Aufbau der Abstand zwischen Probe 1 und HF-Empfangsspule 3 mindestens um die Dicke der beiden Glaswände plus dem Vakuumzwischenraum erhöht wird, so daß der Füllfaktor gegenüber seinem möglichen Optimum signifikant verringert wird. Außerdem können in der kryogenen Flüssigkeit 5 eventuell aufsteigende Blasen die HF-Empfangsspule 3 zu Vibrationen anregen, was das Meßergebnis ebenfalls verschlechtern wird.

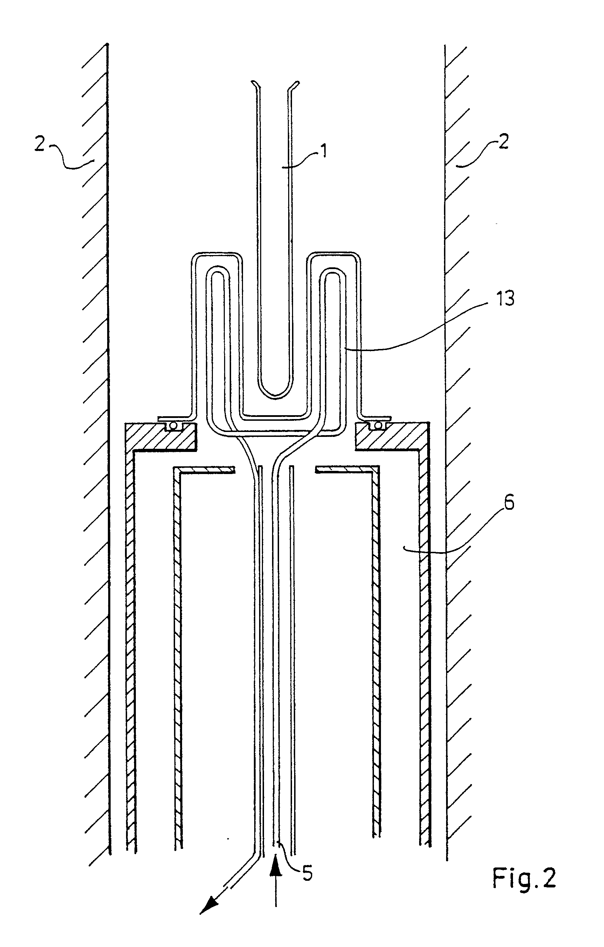

Eine bessere Raumausnutzung und damit einen besseren Füllfaktor ermöglicht die in Fig. 2 gezeigte Anordnung nach dem Stand der Technik, bei der eine hohle HF-Empfangsspule 13 in Form eines gebogenen Röhrchens von der kryogenen Flüssigkeit 5 durchströmt und somit von innen gekühlt wird. Durch die Anordnung der hohlen HF-Empfangsspule 13 im Vakuum wird eine der beiden Glaswände des Glasdewars 4 aus Fig. 1 eingespart. Diese Anordnung hat allerdings den generellen Nachteil, daß die Freiheit bei der Gestaltung der HF-Empfangsspule 13 wesentlich eingeschränkt ist. Insbesondere unterliegt die Verformbarkeit des verwendeten Röhrchens und damit die Geometrie der hohlen HF-Empfangsspule 13 sehr starken Beschränkungen. Daher kann mit dieser im übrigen äußerst schwierig herstellbaren Anordnung ein optimaler Füllfaktor nicht erreicht werden. Ein weiteres Problem ergibt sich aus den Beschränkungen hinsichtlich der verwendbaren Materialien, die eine Suszeptibilitätskompensation der hohlen HF-Empfangsspule 13 erschweren, was weitere Einbußen hinsichtlich der Auflösung und Meßempfindlichkeit zur Folge hat. Ein zusätzliches Problem entsteht durch die Suszeptibilitätsänderungen durch Vibrationen in der hohlen HF-Empfangsspule 13, wenn diese von der kryogenen Flüssigkeit 5 durchströmt wird. Außerdem behindern die bei diesem Aufbau unbedingt erforderlichen dichten Anschlüsse die Austauschbarkeit der hohlen HF-Empfangsspule 13. Schließlich ist das experimentell erreichte Signal-Rausch-Verhältnis bei der in Fig. 2 gezeigten Anordnung erfahrungsgemäß lediglich halb so groß wie das theoretisch erwartete.

Gemäß der vorliegenden Erfindung ist die HF-Empfangsspule 3 ebenfalls im Vakuum 6 angeordnet, so daß lediglich eine Zwischenwand zwischen der Spule und der Probe 1 erforderlich ist, wie in Fig. 3 gezeigt. Bei der erfindungsgemäßen Anordnung wird jedoch die HF-Empfangsspule 3 nicht von innen gekühlt, sondern steht mit einer gekühlten Plattform 7, bzw. in dem gezeigten Ausführungsbeispiel mit einem aus der Plattform 7 ausragenden Kühlfinger 8 in thermischem Kontakt. Die Plattform 7 wird durch einen von der kryogenen Flüssigkeit 5 durchströmten Wärmetauscher 9 gekühlt. Auch die Außenwand 10 des Resonatorraums steht mit der gekühlten Plattform 7 in thermischem Kontakt und befindet sich daher auf niedriger Temperatur. Zwischen der gekühlten Außenwand 10 des Resonators und dem auf Zimmertemperatur gehaltenen Außenmantel 12 des Meßkopfes 14 befindet sich außerdem noch ein Strahlungsschild 11. Meßkopf 14 und Probe 1 werden zur Meßung in das homogene Feld eines Magneten 2 eingeschoben. Die Probe 1 rotiert auf einem Preßluftpolster auf Zimmertemperatur.

Die Temperatur der Probe 1 wird mit einem Gasstrom aufrechterhalten und ggf. reguliert, der die Probe 1 umströmt und über eine Leitung 15 innerhalb des Meßkopfes 14 zugeführt wird.

Die kalte Abschirmung des Resonatorraumes ergibt einen hohen Gütefaktor Q des Resonanzkreises und erniedrigt zudem den Rauschbeitrag der Abschirmung wesentlich. Bei der gezeigten Anordnung wird die HF-Empfangsspule 3 durch Wärmestrahlung der auf Zimmertemperatur befindlichen Probe und den sich daraus ergebenden Wärmefluß lediglich um etwa 1 K erwärmt.

Die direkte Kühlung der HF-Empfangsspule 3 erfolgt bei dem in Fig. 3 gezeigten Ausführungsbeispiel entlang der Anschlüsse. Die Spule ist so ausgebildet, daß ein definierter, HF-mäßig "kalter" Anschluß in der Spulenmitte geschaffen wird, der direkt mit dem Kühlfinger 8 verbunden ist. Im gezeigten Ausführungsbeispiel besteht die HF-Empfangsspule 3 aus einem Metalldraht mit sehr guter elektrischer und thermischer Leitfähigkeit, insbesondere teilweise aus hochreinem Aluminium, Kupfer oder Silber, während die gekühlte Plattform 7 und der daraus ausragende Kühlfinger 8 von einem massiven Kupferblock gebildet werden.

Bei anderen Ausführungsformen besteht die HF-Empfangsspule 3 aus einer auf ein Substrat aufgebrachten, elektrisch leitenden, insbesondere supraleitfähigen Schicht, wie beispielsweise NbTi. Das Substrat kann von einem Saphirrohr gebildet sein, daß für sich oder zusammen mit einem daran angebrachten Kupferblock die gekühlte Plattform 7 bildet.

Bei dem in Fig. 3 gezeigten Ausführungsbeispiel ist ein Anschluß der HF-Empfangsspule 3 ohne Kontakt mit der gekühlten Plattform 7 durch eine Bohrung in der Plattform 7 durchgeführt und wird von der Plattform 7 indirekt gekühlt. Eine gute Kühlung des HF-mäßig "heißen" Anschlusses kann aber zusätzlich erreicht werden, indem dieser durch eine Verbindung mittels eines thermisch gut leitenden Dielektrikums, wie z. B. Saphir, zur Plattform 7 angekoppelt wird.

Bei einer anderen Ausführungsform kann aber auch der Ringspalt zwischen der Bohrung und dem durchgeführten Anschluß mit einem elektrisch nichtleitfähigem Material, z. B. durch eine Metallkeramikdurchführung abgedichtet sein. Durch die Dichtung im Bereich des Wärmetauschers 9 wird ein gegenüber dem Vakuum 6 abgeschlossener Raum gebildet, in welchem sich bei Kühlung mit flüssigem Helium das abdampfende Helium-Rückflußgas befinden kann, das dann den durchgeführten Anschluß der HF-Empfangsspule 9 umgibt und ebenfalls kühlt. Wird die Durchführung mit einem thermisch gut leitenden Dielektrikum realisiert, so kann auch in diesem Falle eine noch bessere Kühlung des "heißen" Anschlusses erreicht werden.

Ein wichtiger Gesichtspunkt für die praktische Verwendung des gesamten Systems sind die Kühlmittelverluste im gekühlten Meßbetrieb. Wird die Anlage mit flüssigem Stickstoff gekühlt, so ist der $LN_2$-Verbrauch relativ bescheiden und auch sowohl vom Preis wie von der Handhabung her recht günstig. Falls jedoch eine tiefere Temperatur der HF-Empfangsspule 3 angestrebt werden soll, muß i. a. mit flüssigem Helium gekühlt werden.

Das Teil des Empfangssystems, das am besten gekühlt sein muß, ist die HF-Empfangsspule 3 selbst. Ihre Temperatur sollte nahe bei 4,2 K liegen. Daraus folgt, daß für ihre Kühlung nicht die Enthalpie des gasförmigen rückfließenden Heliums verwendet werden kann, sondern die gesamte Kühlleistung nur von der Verdampfungswärme des flüssigen Heliums gedeckt werden muß. Darum ist es wichtig, bei der Kühlung der HF-Empfangsspule 3 auf Temperaturen in der Nähe der Heliumtemperatur nur einen minimalen Wärmezustrom zuzulassen. Wird bei der erfindungsgemäßen Anordnung nicht ein ganzer Glasdewar 4, sondern lediglich die HF-Empfangsspule 3 selbst gekühlt, so ist nur diese der direkten Raumtemperaturstrahlung ausgesetzt. Der Rest des Systems ist, wie oben beschrieben, mit einem oder mehreren Strahlungsschilden 11 geschützt und fällt aufgrund des $T^4$-Gesetzes bei der Wärmebilanz ohnehin weit weniger ins Gewicht. Da die Oberfläche der HF-Empfangsspule 3 sehr gering und ihre Reflektivität für Infrarotstrahlung recht hoch ist, ergibt sich für die HF-Empfangsspule 3 alleine eine notwendige Kühlleistung von nur wenigen Milliwatt, was einem Heliumverbrauch von wenigen Millilitern pro Stunde entsprechen würde.

Diese an sich extrem günstige Bilanz kann durch mehrere Faktoren verschlechtert werden:
Es ist durchaus möglich, daß auch eine zweite (Sende- bzw. Entkopplerspule) auf Heliumtemperatur betrieben werden muß, um eine exzessive Rauscheinkopplung von der warmen Sende-/Entkoppelspule in die Empfangsspule zu verhindern. Das würde allein aufgrund der Strahlungsaufheizung zu einer Verdoppelung der Kühlleistung führen. Die in einer solchen Sende- oder insbesondere Entkopplerspule dissipierte Leistung kann ebenfalls beträchtlich sein. Dies kann zu einem beträchtlichen Mehrverbrauch an flüssigem Helium führen. Ist (je nach Geometrie) der Dämpfungs- bzw. Rauschbeitrag einer ungekühlten Resonatorwand (HF-Abschirmung der Empfangsspule) signifikant, so ist es vorteilhaft, diese auf eine entsprechend tiefe Temperatur zu kühlen. Im Extremfall kann dies die gleiche Temperatur sein wie diejenige der Empfangsspule. Dieser Fall ist im Ausführungsbeispiel in Fig. 3 dargestellt.

Somit kann sich die Forderung ergeben, daß alle Metallwände in der unmittelbaren Nähe der HF-Empfangsspule 3 ebenfalls gekühlt sein müssen. Die Kühlung eines solchen HF-Schildes würde ein Mehrfaches der Kühlleistung fordern, die für die Kühlung der HF-Empfangsspule 3 notwendig ist, falls die Temperatur bei 4,2 K liegen müßte. Bei Ausreichen von etwas höheren Temperaturen könnte aber die Enthalpie des gasförmigen Rückfluß-Heliums für diese Kühlung verwendet werden, was eine nur unbedeutende Erhöhung des Gesamt-He-Verbrauchs zur Folge hätte.

Wird z. B. ein Galliumarsenid-Vorverstärker auf Heliumtemperatur betrieben, so ergibt sich durch seine dissipierte Leistung von größenordnungsmäßig 20 mW eine weitere thermische Belastung. Die Kühlung des Vorverstärkers kann aber bei Ausführungsformen der erfindungsgemäßen Anordnung ebenfalls mit der Enthalpie des rückströmenden Heliumgases, das zur Kühlung der Empfangsspule verwendet wurde, gewissermaßen umsonst erfolgen. Das gleiche gilt mit gewissen Einschränkungen betreffs der maximalen Arbeitstemperatur bei Verwendung eines SQUID-Vorverstärkers.

Weiterhin müssen noch die üblichen Verlustquellen dazugerechnet werden, die in jedem Kryostat vorhanden sind (Strahlung, Wärmeleitung entlang den strukturellen Elementen, Wärmeleitung entlang den HF-Koaxialkabeln sowie den Stromversorgungskabeln usw.). Zusammen mit den oben aufgeführten Wärmequellen ergibt sich ein Heliumverlust von insgesamt ca. 10 ml pro Stunde im günstigsten und bis zu ca. einigen Litern pro Stunde im ungünstigsten Fall. Letzerer Fall könnte durch die Verlustleistung einer auf 4,2 K gekühlten Entkopplerspule bedingt sein.

Bei einer Ausführungsform ist der Kryostat als ein Durchflußkryostat in der Form eines üblichen Meßkopfes 14 ausgebildet, der von unten in den Magneten eingeschoben wird. Während des gekühlten Betriebes ist der Durchflußkryostat mit seiner Transferleitung dauernd am Helium-Vorratsdewar angeschlossen. Die in diesem Falle dauernd angeschlossene Transferleitung bildet das am schlechtesten isolierte Glied in der beschriebenen Kryoeinrichtung. Die Verluste in der Transferleitung würden alle übrigen Verluste dominieren. Daher werden bei dieser Ausführungsform die Transferleitungen ebenfalls mit Helium-Rückflußgas gekühlt, so daß aufgrund der Transferleitungen lediglich mit einem Heliumverlust von ungefähr 1 Liter pro Stunde gerechnet werden muß.

Aus den obigen Ausführungen ergibt sich, daß ein im Durchfluß gekühlter Meßkopf 14 in einem nicht allzu ungünstigen Fall mit einem Heliumverlust von ca. 2 Litern pro Stunde betrieben werden kann. Somit würde ein 100 l-Heliumgefäß für eine ganze Arbeitswoche ausreichen, falls nur tagsüber gearbeitet wird. Diesen Kosten muß aber die enorme Leistungssteigerung eines solchen Systems entgegen gehalten werden, die die zusätzlichen Kosten für das flüssige Helium mehr als wettmachen. Ein solcher im Durchfluß gekühlter Meßkopf 14 zeichnet sich durch seine relativ einfache Handhabung, durch Verbrauch an flüssigem Helium nur während der Meßzeit, durch seine Servicefreundlichkeit und seinen einfachen Aufbau aus. Die Kompaktheit der Anordnung ermöglicht auch einen Einsatz in der relativ kleinen Magnetbohrung eines Hochfeldmagneten.

Bei einer Ausführungsform ist der Meßkopf 14 mit integriertem Vorratsgefäß für flüssiges Helium ausgestattet, wodurch eine Senkung des Heliumverbrauchs bei kontinuierlichem Betrieb ermöglicht wird.

Bei einer weiteren Ausführungsform ist das Kühlsystem als Kryocooler mit geschlossenem Kühlkreislauf ausgebildet, was eine integrierte Helium-Rückgewinnung und evtl. -verflüssigung gestattet.

**Patentansprüche**

1. HF-Empfangsspulenanordnung für Kernspinresonanz-Spektrometer mit einer um eine in einem homogenen Magnetfeld angeordneten, ungefähr auf Zimmertemperatur oder höherer Temperatur befindlichen Probe (1) angeordneten, auf weit unter Zimmertemperatur gekühlten HF-Empfangsspule (3) zum Empfangen von Kernspinresonanzsignalen aus der Probe (1), dadurch gekennzeichnet, daß zumindest Teile der HF-Empfangsspule (3) in wärmeleitendem Kontakt mit einer gekühlten Plattform (7) stehen.

2. HF-Empfangsspulenanordnung nach Anspruch 1, dadurch gekennzeichnet, daß die HF-Empfangsspule (3) eine auf ein Substrat aufge- brachte, elektrisch leitende, insbesondere su- praleitfähige Schicht ist.

3. HF-Empfangsspulenanordnung nach Anspruch 2, dadurch gekennzeichnet, daß das Substrat ein verlustarmes Dielektrikum mit einer bei tiefen Temperaturen hohen Wärmeleitfähigkeit, wie z. B. Saphir oder Quarz ist.

4. HF-Empfangsspulenanordnung nach Anspruch 2, dadurch gekennzeichnet, daß das Substrat zusammen mit einem damit in wärmeleitendem Kontakt stehenden Metallblock, insbesondere aus Cu oder Al, die gekühlte Plattform (7) bildet.

5. HF-Empfangsspulenanordnung nach Anspruch 1, dadurch gekennzeichnet, daß die HF-Empfangsspule (3) aus einem Metalldraht, insbesondere hochreine Aluminium- oder Kupferanteile enthaltenden Draht besteht.

6. HF-Empfangsspulenanordung nach Anspruch 5, dadurch gekennzeichnet, daß die HF-Empfangsspule (3) entlang mindestens einem ihrer Anschlüsse in wärmeleitendem Kontakt mit der gekühlten Plattform (7) steht.

7. HF-Empfangsspulenanordung nach einem der vorhergehenden Ansprüche, dadurch gekennzeichnet, daß die HF-Empfangsspule (3) in wärmeleitendem Kontakt mit mindestens einem aus der gekühlten Plattform (7) vorspringenden Kühlfinger steht.

8. HF-Empfangsspulenanordnung nach einem der vorhergehenden Ansprüche, dadurch gekennzeichnet, daß die HF-Empfangsspule (3) in der Spulenmitte in wärmeleitendem Kontakt mit der gekühlten Plattform (7) steht.

9. HF-Empfangsspulenanordnung nach einem der vorhergehenden Ansprüche, dadurch gekennzeichnet, daß die HF-Empfangsspule (3) im Bereich um die Probe im Vakuum (6) angeordnet ist.

10. HF-Empfangsspulenanordnung nach einem der vorhergehenden Ansprüche, dadurch gekennzeichnet, daß die HF-Empfangsspule (3) von einem oder mehreren gekühlten oder ungekühlten Strahlungschilden (11) umgeben ist.

11. HF-Empfangsspulenanordnung nach einem der vorhergehenden Ansprüche, dadurch gekennzeichnet, daß die Kühlung der Plattform (7) mit flüssigem Stickstoff erfolgt.

12. HF-Empfangsspulenanordnung nach einem der Ansprüche 1 bis 10, dadurch gekennzeichnet, daß die Kühlung der Plattform (7) mit flüssigem Helium erfolgt.

13. HF-Empfangsspulenanordnung nach einem der vorhergehenden Ansprüche, dadurch gekennzeichnet, daß ein Anschluß der HF-Empfangsspule (3) ohne Kontakt mit der gekühlten Plattform (7) durch eine Bohrung in der Plattform (7) geführt ist.

14. HF-Empfangsspulenanordnung nach Anspruch 13, dadurch gekennzeichnet, daß der Ringspalt zwischen Bohrung und durchgeführtem Anschluß der HF-Empfangsspule (3) mit elektrisch nichtleitfähigem Material, z. B. durch eine Metallkeramikdurchführung abgedichtet ist.

15. HF-Empfangsspulenanordnung nach Anspruch 13, dadurch gekennzeichnet, daß die HF-Ankopplung der HF-Empfangsspule (3) zu außerhalb des Vakuumraumes liegenden Leitungen bzw. einem Transformationsnetzwerk oder Vorverstärker kapazitiv durch eine dielektrische Trennwand erfolgt.

16. HF-Empfangsspulenanordnung nach Anspruch 14, dadurch gekennzeichnet, daß der durchgeführte Anschluß der HF-Empfangsspule (3) von Helium-Rückflußgas umgeben ist.

17. HF-Empfangsspulenanordnung nach einem der vorhergehenden Ansprüche, dadurch gekennzeichnet, daß der HF-mäßig "heiße" Anschluß der HF-Empfangsspule (3) durch Wärmeleitung mittels eines thermisch gut leitenden Dielektrikums, das in Wärmekontakt zur gekühlten Plattform (7) steht, gekühlt wird.

18. HF-Empfangsspulenanordnung nach einem der Ansprüche 15 bis 17, dadurch gekennzeichnet, daß der durchgeführte Anschluß der HF-Empfangsspule (3) zu einem von Helium-Rückflußgas umgebenen Halbleiter-Vorverstärker bzw. Mischer, insbesondere einem GaAs-Vorverstärker zur Verstärkung des Kernspinresonanz-Signales aus der Probe führt.

19. HF-Empfangsspulenanordnung nach einem der Ansprüche 15 bis 17, dadurch gekennzeichnet, daß der durchgeführte Anschluß der HF-Empfangsspule (3) zu einem ebenfalls von Helium-Rückflußgas umgebenen supraleitenden Mischer oder Verstärker, insbesondere einem SQUID-Vorverstärker zur Verstärkung des Kernspinresonanz-Signales aus der Probe führt.

20. HF-Empfangsspulenanordnung nach einem der vorhergehenden Ansprüche, dadurch gekennzeichnet, daß die innerste Wand, die der HF-Empfangsspule (3) zugewandt ist, gekühlt ist.

21. HF-Empfangsspulenanordnung nach Anspruch 20, dadurch gekennzeichnet, daß die innerste Wand aus einem Material mit niedrigen HF-Verlusten, insbesondere aus einem elektrisch gut leitenden Metall oder einem Supraleiter, besteht.

22. HF-Empfangsspulenanordnung nach einem der vorhergehenden Ansprüche, dadurch gekennzeichnet, daß die Sende- und/oder Entkopplerspule gekühlt ist.

23. HF-Empfangsspulenanordnung nach einem der vorhergehenden Ansprüche, dadurch gekennzeichnet, daß die HF-Empfangsspule (3) zusammen mit dem sie umgebenden Kühlsystem einen Meßkopf (14) bildet, der in das homogene Magnetfeld eingeschoben werden kann und eine Bohrung zur Aufnahme der Probe aufweist.

24. HF-Empfangsspulenanordnung nach Anspruch 23, dadurch gekennzeichnet, daß das Kühlsystem als Durchflußkryostat ausgebildet ist, der mindestens eine Transferleitung für die Zufuhr flüssigen Heliums aus einem Vorratsbehälter aufweist, welche während des gekühlten Betriebs des Kernspinresonanz-Spektrometers von Helium-Rückflußgas umgeben ist.

25. HF-Empfangsspulenanordnung nach einem der Ansprüche 23 oder 24, dadurch gekennzeichnet, daß der Kryostat einen integrierten Vorratsbehälter für flüssiges Helium oder Stickstoff aufweist.

26. HF-Empfangsspulenanordnung nach einem der Ansprüche 23 bis 25, dadurch gekennzeichnet, daß die Kühlung der HF-Empfangsspule (3) und/oder der HF-Abschirmung über Distanzen, die von der Größenordnung der halben Magnetlänge sind, durch Wärmeleitung in einem Metallblock, insbesondere hochreines Al oder Cu, stattfindet.

27. HF-Empfangsspulenanordnung nach Anspruch 23, dadurch gekennzeichnet, daß das Kühlsystem als geschlossener Kühlkreislauf ausgebildet ist.

Fig.1

Fig.2

Fig. 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | REVIEW OF SCIENTIFIC INSTRUMENTS. Bd. 55, Nr. 1, Januar 1984, NEW YORK US Seiten 68 - 74; K. CARDUNER ET AL.: 'Variable-temperature solid-state nuclear-magnetic-resonance probe for superconducting magnets operating in the range 3-350 K ' * Seite 68 - 70, Kapitel "Introduction" und "Description of NMR Probe" EP 91105315030* * Abbildungen 1,2 * – – – | 1,3,5-7,9, 10,12,23 | G 01 R 33/34 |
| A | EP-A-0 303 095   (BRUKER ANALYTISCHE MESSTECH-NIK) * Spalte 2, Zeile 33 - Spalte 6, Zeile 57 * * Abbildungen 1-3 * – – – | 1,5,8 | |
| A | US-A-3 826 972   (E. P. DAY ET AL.) * Spalte 1, Zeile 31 - Spalte 2, Zeile 56 * * Spalte 3, Zeile 46 - Spalte 4, Zeile 29 * * Abbildungen 1,4 * – – – | 1,5,10 | |
| A | REVIEW OF SCIENTIFIC INSTRUMENTS. Bd. 57, Nr. 3, März 1986, NEW YORK US Seiten 404 - 409; M. G. RICHARDS ET AL.: 'Cryogenic GaAs FET amplifiers and their use in NMR detection ' * Seite 404, Kapitel "Introduction" * * Seite 406 - 407, Kapitel II * * Abbildung 2 * – – – | 18 | |
| | | | RECHERCHIERTE SACHGEBIETE (Int. Cl.5) |
| A | REVIEW OF SCIENTIFIC INSTRUMENTS. Bd. 57, Nr. 3, März 1986, NEW YORK US Seiten 410 - 413; L. J. FRIED-MAN ET AL.: 'Direct detection of low-frequency NMR using a dc SQUID ' * Seite 410-412, Kapitel "Introduction" und "Design and Construction" * * Abbildungen 1,2 * – – – | 19 | G 01 R |
| A | REVIEW OF SCIENTIFIC INSTRUMENTS. Bd. 36, Nr. 10, 1965, NEW YORK US Seiten 1509 - 1510; S. MEIBOOM, R. C. HEWITT: 'High Resolution NMR Probe Suitable for Use in a Superconducting Solenoid ' * der ganze Artikel * – – – – – | 1-3 | |

Der vorliegende Recherchenbericht wurde für alle Patentansprüche erstellt

| Recherchenort | Abschlußdatum der Recherche | Prüfer |
|---|---|---|
| Den Haag | 17 Juli 91 | VOLMER J.W. |